# EUROPEAN PATENT APPLICATION

(11) **EP 1 995 786 A1**
(43) Date of publication of application: **26.11.2008**
(21) Application number: 08008599.6
(22) Date of filing: 07.05.2008
(51) Int. Cl.: H01L 29/04, H01L 29/20, H01L 33/00, H01S 5/343, C30B 25/18, H01S 5/02

(54) **GaN substrate, and epitaxial substrate and semiconductor light-emitting device employing the substrate**

(30) Priority: 17.05.2007 JP 2007132035
(71) Applicant: Sumitomo Electric Industries, Ltd., Osaka-shi, Osaka 541-0041 (JP)
(72) Inventor: Katsuhi, Akita, Itami-shi Hyogo 664-0016 (JP)
(74) Representative: Grünecker, Kinkeldey, Stockmair & Schwanhäusser Anwaltssozietät

(57) **Abstract**

GaN substrate (30) whose growth plane (30a) is oriented off-axis with respect to either the m-plane or the *a*-plane. That is, in the GaN substrate (30), the growth plane (30a) is either an *m*-plane or an *a*-plane that has been misoriented. Inasmuch as the m-plane and the *a*-plane are nonpolar, utilizing the GaN substrate (30) to fabricate a semiconductor light-emitting device (60) averts the influence of piezoelectric fields, making it possible to realize superior emission efficiency. Imparting to the growth plane the off-axis angle in terms of either the *m*-plane or the *a*-plane realizes high-quality morphology in crystal grown on the substrate. Utilizing the GaN substrate to fabricate semiconductor light-emitting devices enables as a result the realization of further improved emission efficiency.

## Description

### BACKGROUND OF THE INVENTION

### Technical Field

The present invention relates to GaN substrates, and to epitaxial substrates and semiconductor light-emitting devices in which the GaN substrates are employed.

### Description of the Related Art

In the growth of crystalline GaN substrates, traditionally the *c*-plane has in general been employed. Inasmuch as the *c*-plane is a polar plane it generates piezoelectric fields, which have been one cause of degradation in the emission efficiency of light-emitting devices employing GaN substrates. Especially in devices employing an emission layer containing indium in order to realize emission of light in the green region, the consequently enlarged lattice mismatch between the layer and the GaN substrate further degrades device emission efficiency. (Reference is made to A.E. Romanov, et al., "Strain-Induced Polarization in Wurtzite III-Nitride Semipolar Layers," Journal of Applied Physics, vol. 100, article 023522, 2006; Mathew C. Schmidt et al., "Demonstration of Nonpolar m-Plane InGaN/GaN Laser Diodes," Japanese Journal of Applied Physics, Vol. 46, No. 9, 2007, pp. L190-L191; and Kuniyoshi Okamoto et al., "Continuous-Wave Operation of m-Plane InGaN Multiple Quantum Well Laser Diodes," Japanese Journal of Applied Physics, Vol. 46, No. 9, 2007, pp. L187-L189.)

### BRIEF SUMMARY OF THE INVENTION

The inventors' concerted research efforts culminated in newly discovering technology effectively improving the emission efficiency in semiconductor light-emitting devices applied to the green region in particular.

An object of the present invention, brought about in order to resolve the problems touched upon above, is to make available GaN substrates-and epitaxial substrates and semiconductor light-emitting devices utilizing the substrates-that enable designing for improved emission efficiency in semiconductor light-emitting devices.

In a GaN substrate involving the present invention, the growth plane is oriented off-axis in terms of either the *m*-plane or the *a*-plane.

In this GaN substrate, the growth plane is an *m*-plane or *a*-plane, either of which is misoriented. Inasmuch as the *m*-plane and the *a*-plane are nonpolar planes, utilizing the GaN substrate to fabricate semiconductor light-emitting devices averts the influence of piezoelectric fields, making it possible to realize high emission efficiency The inventors then novelly found that providing the off-axis angle in terms of either the *m*-plane or the *a*-plane made possible the realization of high-quality crystal morphology. A result of these advantages is that utilizing the GaN substrate to fabricate semiconductor light-emitting devices enables the realization of further improved emission efficiency

In one aspect, the off-axis angle may be within 1.0 degrees. This implementation allows higher-quality crystal morphology to be realized, enabling further emission-efficiency improvement in semiconductor light-emitting devices to be actualized.

In another aspect, the off-axis angle may be inside a range of 0.03 to 0.5 degrees. This implementation allows higher emission efficiency to be realized.

In yet another aspect, the misorientation axis may be inclined in a <0001> direction.

In a further aspect, the growth plane is a plane oriented off-axis with respect to the *m*-plane, wherein the misorientation axis may be inclined in a <11-20> direction. In an alternative aspect, the growth plane is a plane oriented off-axis with respect to the *a*-plane, wherein the misorientation axis may be inclined in a <1-100> direction.

With an epitaxial substrate involving the present invention, an epitaxial layer is deposited onto a growth plane that is a GaN substrate plane oriented off-axis with respect to either the *m*-plane or the *a*-plane.

In this epitaxial substrate, an InGaN layer is deposited onto a GaN substrate in which the growth plane is an *m*-plane or an *a*-plane, either of which is misoriented. Inasmuch as the *m*-plane and the *a*-plane are nonpolar planes, utilizing this epitaxial substrate to fabricate semiconductor light-emitting devices averts the influence of piezoelectric fields, making it possible to realize high emission efficiency The inventors then novelly found that providing the off-axis angle with respect to either the *m*-plane or the *a*-plane made possible the realization of high-quality crystal morphology. A result of these advantages is that utilizing the epitaxial substrate to fabricate semiconductor light-emitting devices enables the realization of further improved emission efficiency.

With a semiconductor light-emitting device involving the present invention, an emission layer containing InGaN is formed onto a growth plane that is a GaN substrate plane oriented off-axis with respect to either the *m*-plane or the *a*-plane.

In this semiconductor light-emitting device, an emission layer is deposited onto a GaN substrate in which the growth plane is an *m*-plane or an *a*-plane, either of which is misoriented. Inasmuch as the *m*-plane and the *a*-plane are nonpolar planes, with this semiconductor light-emitting device the influence of piezoelectric fields is averted and thus high emission efficiency is realized. The inventors then novelly found that providing the off-axis angle in terms of either the *m*-plane or the *a*-plane made possible the realization of high-quality crystal morphology. A result of these advantages is that the semiconductor light-emitting device realizes further improved emission efficiency.

The present invention makes available GaN substrates-and epitaxial substrates and semiconductor light-emitting devices utilizing the substrates-that enable designing for improved emission efficiency in semiconductor light-emitting devices.

From the following detailed description in conjunction with the accompanying drawings, the foregoing and other objects, features, aspects and advantages of the present invention will become readily apparent to those skilled in the art.

### BRIEF DESCRIPTION OF THE SEVERAL VIEWS OF THE DRAWINGS

Fig. 1 is a configurational outline diagram representing a vapor deposition reactor employed in embodying the present invention;
Fig. 2 is a view depicting a GaN ingot prepared using the vapor deposition reactor of Fig. 1:
Fig. 3 is a schematic diagram illustrating crystallographic plane orientation in GaN;
Figs. 4 and 5 are oblique views representing a GaN substrate involving embodiments of the present invention;
Fig. 6 is an oblique view representing an epitaxial substrate involving embodiments of the present invention;
Fig. 7 is diagram representing the layered structure of a semiconductor light-emitting device involving embodiments of the present invention; and
Figs. 8A-8C are photomicrographs showing surface morphologies involving embodiments of the present invention.

### DETAILED DESCRIPTION OF THE INVENTION

Hereinafter, referring to the accompanying drawings, an explanation of what is contemplated to be the best mode in embodying the present invention will be made in detail. It should be understood that, with identical or equivalent elements being labeled with the same reference marks, if the description would be redundant, that description is omitted.

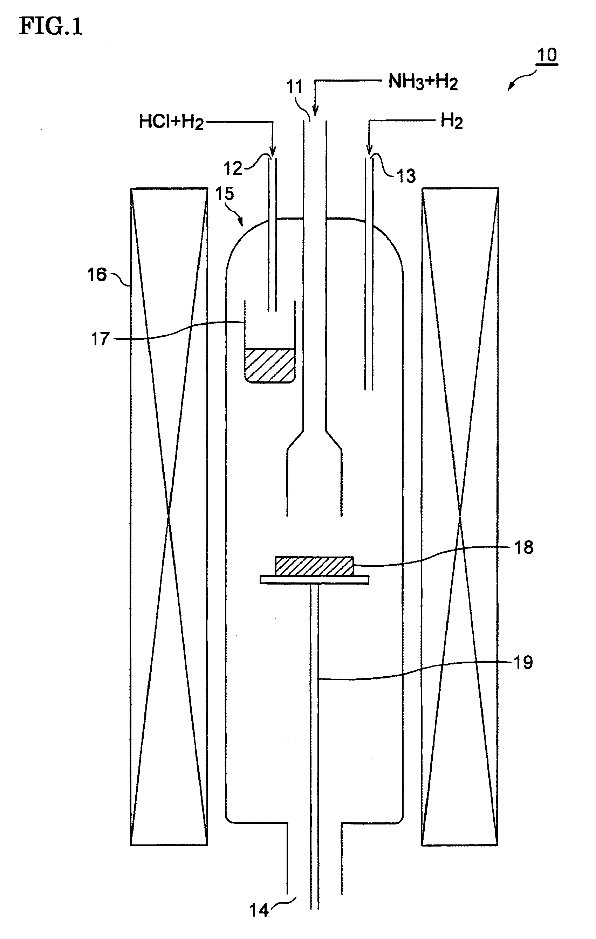

A procedure for preparing GaN substrates utilized in fabricating semiconductor light-emitting devices involving the present invention will be explained. The GaN substrates are prepared by means of an HVPE reactor such as is represented in Fig. 1.

Reference then is made to Fig. 1, a diagram representing an atmospheric-pressure HVPE reactor 10. The reactor comprises: a reaction chamber 15 having a first gas-introduction port 11, a second gas-introduction port 12, a third gas-introduction port 13, and an exhaust-gas port 14; and a resistive heater 16 for heating the reaction chamber 15. Further, a Ga metal source boat 17 and a rotating support post 19 that supports a GaAs substrate 18 are provided inside the reaction chamber 15.

Then, employing an approximately 50- to 150-mm (2- to 6-inch) diameter GaAs (111)A substrate as the GaAs substrate 18, the temperature of the GaAs substrate 18 is ramped up to and held at approximately 450°C to 530°C by the resistive heater 16, in which state hydrogen chloride (HCl) at 4 x 10⁻⁴ atm to 4 x 10⁻³ atm pressure is introduced through the second gas-introduction port 12 to the Ga metal source boat 17. This process generates gallium chloride (GaCl) by the reaction of Ga metal and hydrogen chloride. Subsequently, ammonia (NH₃) is introduced through the first gas-introduction port 11 at 0.1 atm to 0.3 atm pressure to react NH₃ and GaCl in the proximity of the GaAs substrate 18, generating gallium nitride (GaN).

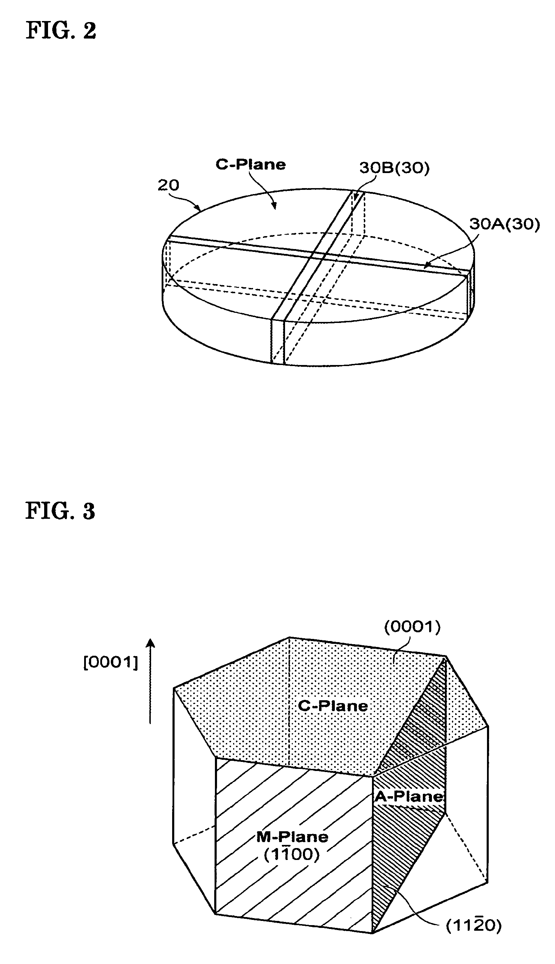

It will be appreciated that hydrogen (H₂) is introduced as a carrier gas into the first gas-introduction port 11 and the second gas-introduction port 12, while hydrogen (H₂) alone is introduced into the third gas-introduction port 13. Growing GaN under conditions like these for an approximately 20- to approximately 40-minute interval thick-film deposits a 5mm-thick GaN layer atop the GaAs substrate, forming a GaN ingot 20 as depicted in Fig. 2.

Then the GaN ingot 20 obtained in the manner just described is sliced approximately perpendicularly with respect to the *c*-plane, which is the growth plane, to cut out GaN substrates 30 utilized in the fabrication of semiconductor light-emitting devices of the present embodiment. In the process, slicing so as to expose the *m*-plane (that is, the (1-100) plane)-which, as indicated in Fig. 3, is a plane perpendicular to the *c*-plane-makes it possible to obtain a GaN substrate with the *m*-plane being the growth plane. Likewise, slicing so that the *a*-plane (that is, the (11-20) plane)-which is a plane perpendicular to the *c*-plane-is exposed makes it possible to obtain a GaN substrate with the *a*-plane being the growth plane. Thanks to *m*-planes and *a*-planes being nonpolar, in implementations in which semiconductor light-emitting devices are fabricated utilizing a GaN substrate with the *m*-plane or *a*-plane being the growth plane, the influence of piezoelectric fields can be averted, making the realization of high emission efficiency possible.

In cutting the GaN substrates from the GaN ingot 20, however, the ingot is sliced in such a manner as to produce the GaN substrates 30 (30A, 30B) provided with a predetermined misorientation angle greater than 0 degrees. Herein, the GaN substrate 30A is a substrate with the growth plane being a plane that is oriented off-axis (> 0 degrees) with respect to the *m*-plane, while the GaN substrate 30B is a substrate with the growth plane being a plane that is oriented off-axis (> 0 degrees) with respect to the *a*-plane.

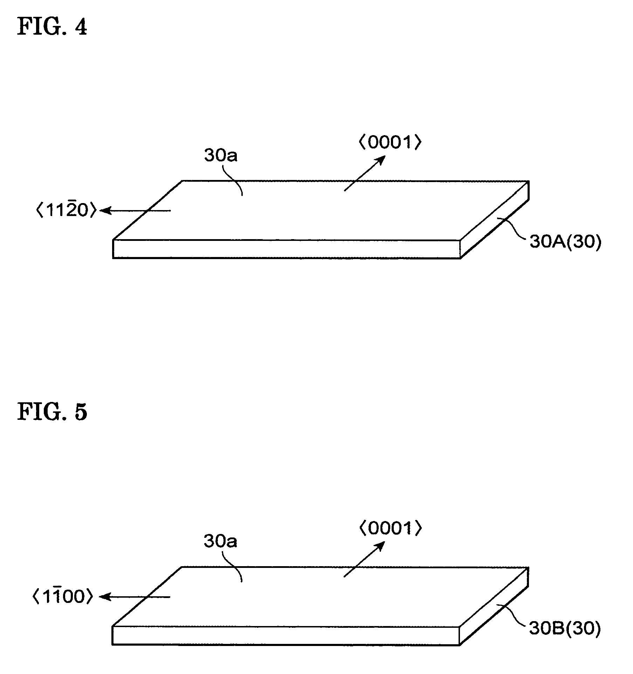

The GaN substrate 30A is, as depicted in Fig. 4, in the form of a rectangle 5 mm x 20 mm square. Its growth plane 30a, then, is a plane oriented off-axis with respect to the *m*-plane. It will be appreciated that the misorientation axis is inclined in either a <0001> direction or a <11-20> direction, which are orthogonal to each other.

The GaN substrate 30B is, as depicted in Fig. 5, in the form of a rectangle 5 mm x 20 mm square, as is the GaN substrate 30A. Its growth plane 30a, then, is a plane oriented off-axis with respect to the *a*-plane. It will be appreciated that the misorientation axis is inclined in either a <0001> direction or a <1-100> direction, which are orthogonal to each other.

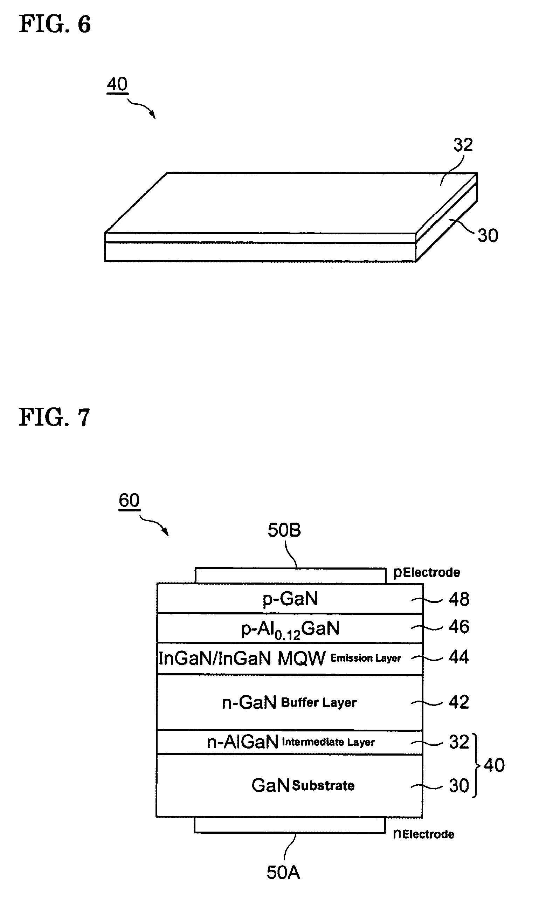

Next, an epitaxial layer 32 is deposited on the growth plane 30a of the GaN substrate 30 obtained in the foregoing manner, forming an epitaxial substrate such as is represented in Fig. 6. The epitaxial layer 32 is composed of AlGaN, and is deposited using a publicly known film deposition apparatus (for example, an MOCVD reactor).

Further, as illustrated in Fig. 7, an *n*-GaN buffer layer 42, an InGaN/InGan-MQW (multiple quantum well) emission layer 44, a *p*-AlGaN layer 46, and a p-GaN layer 48 are deposited in order onto the epitaxial substrate 40, and then an *n*-electrode 50A and a *p*-electrode 50B are furnished to complete fabrication of a semiconductor light-emitting device 60 (LED) involving the present invention. Because this semiconductor light-emitting device 60 has the emission layer 44 containing InGaN, it emits light in the green region, of wavelength longer than the blue region.

Capping intensive research, the inventors confirmed by the following embodiments that improved emission efficiency could be effectively designed for by utilizing the above-described GaN substrates 30 in the fabrication of this kind of semiconductor light-emitting device 60.

### Embodiments

Below, the present invention will, according to embodiments thereof, be explained in further detail, yet the present invention is not limited to these embodiments.

### Embodiment 1

To begin with, GaN substrate Samples 1 through 14, which were the same as or equivalent to the above-described GaN substrate 30A-GaN substrates 5 mm × 20 mm square, differing, as in Table I below, in off-axis angle with respect to the *m*-plane-were prepared according to the same procedure as that of the embodiment mode set forth above. In particular, among Samples 1-14, the misorientation axis in Samples 1-7 was a <11-20> direction, and in Samples 8-14 the misorientation axis was a <0001> direction. It should be noted that the crystallographic plane orientation (off-axis angle) of the GaN substrates was characterized by x-ray diffraction, with the off-axis angle measurement accuracy being ±0.01 degrees.

**Table I**

| | | | | | | | |
|---|---|---|---|---|---|---|---|
| Off-axis angle | 0.00 | 0.03 | 0.1 | 0.3 | 0.5 | 1.0 | 2.0 |
| <11-20> direction | Sample 1 | Sample 2 | Sample 3 | Sample 4 | Sample 5 | Sample 6 | Sample 7 |
| <0001> direction | Sample 8 | Sample 9 | Sample 10 | Sample 11 | Sample 12 | Sample 13 | Sample 14 |

Then, an MOCVD reactor was employed to form epitaxial layers onto the growth plane of each of the above-noted Samples 1-14 and thereby fabricate LEDs having the layered structure depicted in Fig. 7. Atomic force microscopy (AFM) was then employed to measure, in a 50 µm x 50 µm measurement area, the surface roughness of the samples, whereupon the measurement results were as set forth in Table II below.

**Table II**

| | | | | | | | |
|---|---|---|---|---|---|---|---|
| Off-axis angle | 0.00 | 0.03 | 0.1 | 0.3 | 0.5 | 1.0 | 2.0 |
| <11-20> direction | Sample 1 | Sample 2 | Sample 3 | Sample 4 | Sample 5 | Sample 6 | Sample 7 |
| Roughness (*Ra*) | 17 nm | 9 nm | 7 nm | 4 nm | 5 nm | 7 nm | 11 nm |
| <0001> direction | Sample 8 | Sample 9 | Sample 10 | Sample 11 | Sample 12 | Sample 13 | Sample 14 |
| Roughness (*Ra*) | 16 nm | 8 nm | 5 nm | 3 nm | 4 nm | 6 nm | 10 nm |

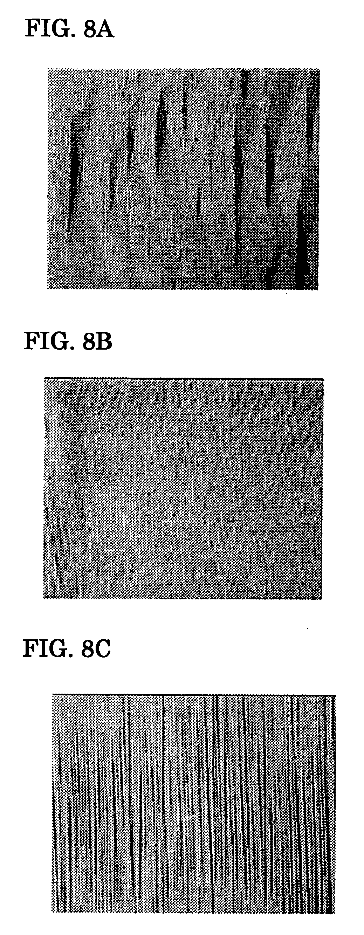

As is evident from the measurements presented in Table II, the surface roughness of Sample 1 and Sample 8 was considerable, being over 15 nm. Thus, it was understood that in implementations in which epitaxial layers were grown onto a growth plane misoriented 0 degrees (the *m*-plane), the planarity of the surface proved to be poor. When the surface of Sample 1 and Sample 8 was examined in actuality, an undulating morphology such as shown in Fig. 8A was observed.

As is also apparent from the measurement results in Table II, apart from Samples 1 and 8, the roughness was slight, being under 15 nm.

In particular, it was found that when the epitaxial layers were grown onto a growth plane having an off-axis angle that was inside a range of 0.03 to 1.0 degrees, as was the case with Samples 2-6 and Samples 9-13, the surface planarity proved to be exceedingly satisfactory. When the surface of Samples 2-6 and Samples 9-13 was examined in actuality, an extremely planar morphology or otherwise a shallowly stepped morphology such as shown in Fig. 8B was observed.

Meanwhile, in implementations in which the epitaxial layers were grown onto a growth plane having an off-axis angle of 2.0 degrees, as was the case with Sample 7 and Sample 14, although the surface planarity was satisfactory, when the surface of Sample 7 and Sample 14 was examined in actuality, a deeply stepped morphology such as shown in Fig. 8C was observed. The causative factor behind this stepped morphology is thought to be unevenness (scratches) in the GaN substrate growth plane.

In sum, from the measurement results in Table II, it became apparent that as the off-axis angle is increased from the instance in which the angle is 0 degrees, the surface planarity becomes better and better, and that the best planarity is obtained with an off-axis angle in the proximity of 0.3 degrees. As the off-axis angle is then further increased from 0.3 degrees, the surface planarity deteriorates (decrease in inter-step interval, enlargement of step slope). Because augmenting the off-axis angle is prohibitive of maintaining the level of planarity that semiconductor light-emitting devices demand, an off-axis angle of 1.0 degrees or less is favorably suitable.

Further, the emission-spectrum electroluminescence (EL) intensity, at 450 nm peak wavelength, of LEDs fabricated utilizing the aforementioned Samples 1-14 was measured, whereupon the measurement results were as presented in Table III below. It should be understood that the EL intensity measurements in Table III are given as relative intensities, letting the EL intensity of 0.3-degree-off-axis-angle Samples 4 and 11 be unity.

**Table III**

| | | | | | | | |
|---|---|---|---|---|---|---|---|
| Off-axis angle | 0.00 | 0.03 | 0.1 | 0.3 | 0.5 | 1.0 | 2.0 |
| <11-20> direction | Sample 1 | Sample 2 | Sample 3 | Sample 4 | Sample 5 | Sample 6 | Sample 7 |
| EL intensity | 0.3 | 0.8 | 0.90 | 1 | 0.95 | 0.8 | 0.5 |
| <0001> direction | Sample 8 | Sample 9 | Sample 10 | Sample 11 | Sample 12 | Sample 13 | Sample 14 |
| EL intensity | 0.2 | 0.85 | 0.95 | 1 | 0.98 | 0.8 | 0.6 |

As is evident from the measurement results in Table III, with Samples 2-7 and Samples 9-14 a high EL intensity could be obtained, whereas with Samples 1 and 8 a sufficiently high EL intensity could not be obtained. This outcome, referring to the Table II measurement results, is believed to originate in the crystalline properties of the samples. That is, with Samples 2-7 and Samples 9-14, owing to the fact that favorable crystal growth could take place, the crystallinity of the epitaxial layers proved to be superior, and thus it is thought that as a result the surface planarity proved to be superior, and high-level EL intensity was obtained. The samples with an off-axis angle of 0.03 to 0.5 degrees especially yielded high-level EL intensities. Conversely, with Samples 1 and 8, inasmuch as satisfactory crystal growth could not take place, the crystallinity of the epitaxial layers proved to be inferior, and thus it is thought that as a result the surface planarity proved to be poor, which degraded the EL intensity.

From the foregoing tests, it was confirmed that in the fabrication of semiconductor light-emitting devices, adopting a GaN substrate that has as its growth plane a plane misoriented from the *m*-plane by a predetermined angle (preferably 1.0 degrees or less, more preferably 0.03 to 0.5 degrees) enables superior emission efficiency to be realized.

### Embodiment 2

In a manner similar to that of Embodiment 1, GaN substrate Samples 15 through 28, which were the same as or equivalent to the above-described GaN substrate 30B-GaN substrates 5 mm × 20 mm square, differing, as in Table IV below, in off-axis angle with respect to the *a*-plane-were prepared according to the same procedure as that of the embodiment mode set forth earlier. In particular, among Samples 15-28, the misorientation axis in Samples 15-21 was a <1-100> direction, and in Samples 22-28 the misorientation axis was a <0001> direction. It should be noted that the crystallographic plane orientation (off axis angle) of the GaN substrates was characterized by x-ray diffraction, with the off-axis angle measurement accuracy being ±0.01 degrees.

**Table IV**

| | | | | | | | |
|---|---|---|---|---|---|---|---|
| Off-axis angle | 0.00 | 0.03 | 0.1 | 0.3 | 0.5 | 1.0 | 2.0 |
| <1-100> direction | Sample 15 | Sample 16 | Sample 17 | Sample 18 | Sample 19 | Sample 20 | Sample 21 |
| <0001> direction | Sample 22 | Sample 23 | Sample 24 | Sample 25 | Sample 26 | Sample 27 | Sample 28 |

Then, an MOCVD reactor was employed to form epitaxial layers onto the growth plane of each of the above-noted Samples 15-28 and thereby fabricate LEDs having the layered structure illustrated in Fig. 7. Atomic force microscopy (AFM) was then employed to measure, in a 50 µm x 50 µm measurement area, the surface roughness of the samples, whereupon the measurement results were as set forth in Table V below.

**Table V**

| | | | | | | | |
|---|---|---|---|---|---|---|---|
| Off-axis angle | 0.00 | 0.03 | 0.1 | 0.3 | 0.5 | 1.0 | 2.0 |
| <1-100> direction | Sample 15 | Sample 16 | Sample 17 | Sample 18 | Sample 19 | Sample 20 | Sample 21 |
| Roughness (*Ra*) | 18 nm | 9 nm | 7 nm | 4 nm | 5 nm | 7 nm | 12 nm |
| <0001> direction | Sample 22 | Sample 23 | Sample 24 | Sample 25 | Sample 26 | Sample 27 | Sample 28 |
| Roughness (*Ra*) | 17 nm | 8 nm | 5 nm | 3 nm | 4 nm | 6 nm | 11 nm |

As is evident from the measurements presented in Table V, the surface roughness of Sample 15 and Sample 22 was large, being over 15 nm. Thus, it was understood that in implementations in which epitaxial layers were grown onto a growth plane misoriented 0 degrees (the *a*-plane), the planarity of the surface proved to be poor. When the surface of Sample 15 and Sample 22 was examined in actuality, an undulating morphology such as shown in Fig. 8A was observed.

As is also apparent from the measurement results in Table V, apart from Sample 15 and Sample 22, the roughness was slight, being under 15 nm.

In particular, it was realized that when the epitaxial layers were grown onto a growth plane having an off-axis angle that was inside a range of 0.03 to 1.0 degrees, as was the case with Samples 16-20 and Samples 23-27, the surface planarity proved to be extremely good. When the surface of Samples 16-20 and Samples 23-27 was examined in actuality, an exceedingly planar morphology or else a shallowly stepped morphology such as shown in Fig. 8B was observed.

Meanwhile, in implementations in which the epitaxial layers were grown onto a growth plane having an off-axis angle of 2.0 degrees, as was the case with Sample 21 and Sample 28, although the surface planarity was satisfactory, when the surface of Sample 21 and Sample 28 was examined in actuality, a deeply stepped morphology such as shown in Fig. 8C was observed. This stepped morphology is believed to originate in unevenness (scratches) in the GaN substrate growth plane.

In sum, from the measurement results in Table V, it became apparent that as the off-axis angle is increased from the instance in which the angle is 0 degrees, the surface planarity becomes better and better, and that the best planarity is obtained with an off-axis angle in the proximity of 0.3 degrees. As the off-axis angle is then further increased from 0.3 degrees, the surface planarity deteriorates (decrease in the spacing between and enlargement of the slope of the steps). Owing to the fact that augmenting the off-axis angle means that the level of planarity requisite for semiconductor light-emitting devices cannot be maintained, an off-axis angle of 1.0 degrees or less is best-suited to the circumstances.

Further, the emission-spectrum EL intensity, at 450 nm peak wavelength, of LEDs fabricated utilizing the aforementioned Samples 15-28 was measured, whereupon the measurement results were as presented in Table VI below. It should be noted that the EL intensity measurements in Table VI are given as relative intensities, letting the EL intensity of 0.3-degree-off-axis-angle Samples 18 and 25 be unity.

**Table VI**

| | | | | | | | |
|---|---|---|---|---|---|---|---|
| Off-axis angle | 0.00 | 0.03 | 0.1 | 0.3 | 0.5 | 1.0 | 2.0 |
| <1-100> direction | Sample 15 | Sample 16 | Sample 17 | Sample 18 | Sample 19 | Sample 20 | Sample 21 |
| EL intensity | 0.3 | 0.8 | 0.90 | 1 | 0.95 | 0.8 | 0.5 |
| <0001> direction | Sample 22 | Sample 23 | Sample 24 | Sample 25 | Sample 26 | Sample 27 | Sample 28 |
| EL intensity | 0.2 | 0.85 | 0.95 | 1 | 0.98 | 0.8 | 0.6 |

As is evident from the measurement results in Table VI, with Samples 16-21 and Samples 23-28 a high EL intensity could be obtained, whereas with Samples 15 and 22 a sufficiently high EL intensity could not be obtained. This outcome, referring to the Table V measurement results, is believed to originate in the crystalline properties of the samples. That is, with Samples 16-21 and Samples 23-28, owing to the fact that favorable crystal growth could take place, the crystallinity of the epitaxial layers turned out to be superior, wherein it is thought that as a result the surface planarity turned out to be superior, and high-level EL intensity was obtained. The samples with an off-axis angle of 0.03 to 0.5 degrees especially yielded high-level EL intensities. Conversely, with Samples 15 and 22, inasmuch as satisfactory crystal growth could not take place, the crystallinity of the epitaxial layers turned out to be inferior, wherein it is thought that as a result the surface planarity proved to be poor, lowering the EL intensity.

From the foregoing tests, it was confirmed that in the fabrication of semiconductor light-emitting devices, adopting a GaN substrate with a plane misoriented from the *a*-plane by a predetermined angle (preferably 1.0 degrees or less, more preferably 0.03 to 0.5 degrees) being the growth plane makes it possible to realize superior emission efficiency.

The present invention is not limited to the above-described embodiments, in that various modifications are possible. For example, the semiconductor light-emitting devices are not limited to LEDs having a MQW emission layer, but may be LEDs, laser diodes, and similar devices that have a different light-emitting structure.

## Claims

1. A GaN substrate whose growth plane is a plane oriented off-axis with respect to either the *m*-plane or *a*-plane.

2. A GaN substrate as set forth in claim 1, wherein the off-axis angle is within 1.0 degrees.

3. A GaN substrate as set forth in claim 1, wherein the off-axis angle is inside a range of 0.03 to 0.5 degrees

4. A GaN substrate as set forth in claim 1, wherein the misorientation axis is inclined in a <0001> direction.

5. A GaN substrate as set forth in claim 1, wherein the growth plane is oriented off-axis with respect to the *m*-plane, and the misorientation axis is inclined in a <11-20> direction.

6. A GaN substrate as set forth in claim 1, wherein the growth plane is oriented off-axis with respect to the *a*-plane, and the misorientation axis is inclined in a <1-100> direction.

7. An epitaxial substrate having an epitaxial layer deposited onto a growth plane that is a GaN substrate plane oriented off-axis with respect to either the *m*-plane or *a*-plane.

8. A semiconductor light-emitting device having an InGaN-containing emission layer formed onto a growth plane that is a GaN substrate plane oriented off-axis with respect to either the *m*-plane or *a*-plane.
